(19) Europäisches Patentamt
European Patent Office
Office européen des brevets

(11) **EP 4 770 320 A1**

(12) **EUROPEAN PATENT APPLICATION**

(43) Date of publication:
**01.07.2026   Bulletin 2026/27**

(21) Application number: **25219037.6**

(22) Date of filing: **27.11.2025**

(51) International Patent Classification (IPC):
**H10D 30/60** (2025.01)          **G09G 3/3233** (2016.01)
**H10D 62/10** (2025.01)          **H10K 59/12** (2023.01)

(52) Cooperative Patent Classification (CPC):
**H10K 59/1213; G09G 3/3233; H10D 30/601;
H10D 30/603; H10D 62/126; H10K 59/12;
H10K 59/1216;** G09G 2300/0819; G09G 2300/0861

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  **31.12.2024  KR 20240202053**

(71) Applicant: **Samsung Display Co., Ltd.
Yongin-si, Gyeonggi-do 17113 (KR)**

(72) Inventors:
• **Kang, Sinchul
Yongin-si, Gyeonggi-do 17113 (KR)**
• **Goh, Joon-Chul
Yongin-si, Gyeonggi-do 17113 (KR)**

(74) Representative: **Gulde & Partner
Patent- und Rechtsanwaltskanzlei mbB
Berliner Freiheit 2
10785 Berlin (DE)**

(54)    **PIXEL AND ELECTRONIC DEVICE INCLUDING THE SAME**

(57)    A pixel includes: a driving transistor including: a source region electrically connected to a driving voltage line, which receives a driving voltage and disposed in one side of a semiconductor substrate, a drain region disposed in an opposite side of the semiconductor substrate, a channel region disposed in a portion of the semiconductor substrate between the source region and the drain region and having an asymmetrical shape with respect to a center of the channel region, an insulating layer disposed on the channel region, and a gate electrode disposed on the insulating layer and overlapping the channel region in a plan view, wherein the driving transistor is configured to generate a driving current, and a light-emitting element, which generates light based on the driving current and including an anode electrode and a cathode electrode.

FIG. 4

EP 4 770 320 A1

# FIG. 10

TR'

SUB

SR

A1

CH

GE

A2

DR

D1

D3 — D2

**Description**

BACKGROUND

1. Technical Field

Embodiments relate generally to a pixel. More particularly, embodiments relate to the pixel and an electronic device including the same.

2. Description of the Related Art

As information technology develops, the importance of display devices, which are communication media between users and information, is being highlighted. Accordingly, the use of display devices such as a liquid crystal display device, an organic light emitting display device, a plasma display device, and the like is increasing.

Recently, display devices using high-resolution micro OLED are being manufactured. The high-resolution micro OLED may be OLEDoS (organic light emitting diode on silicon) formed using a semiconductor process based on silicon wafers.

SUMMARY

Embodiments provide a pixel including a driving transistor with improved driving characteristics.

Embodiments provide an electronic device including the pixel.

A pixel according to embodiments of the present disclosure includes a driving transistor including: a source region electrically connected to a driving voltage line, which receives a driving voltage and disposed in (or on) one side of a semiconductor substrate, a drain region disposed in (or on) the other side of the semiconductor substrate, a channel region disposed in a portion of the semiconductor substrate between the source region and the drain region, an insulating layer disposed on the channel region, and a gate electrode disposed on the insulating layer and overlapping the channel region in a plan view, wherein the driving transistor is configured to generate a driving current, and an offset region is formed between the source region and the channel region in the driving transistor in the plan view, and a light-emitting element, which generates light based on the driving current and including an anode electrode and a cathode electrode.

In an embodiment, a resistance may be formed by (or in) the offset region between the source region and the gate electrode.

In an embodiment, the gate electrode may partially overlap the channel region and does not overlap the source region in the plan view.

In an embodiment, a shortest length of the offset region in the plan view may be about 1.7 to about 10 times a thickness of the insulating layer.

In an embodiment, a common voltage line, which receives a common voltage may be connected to the cathode electrode, and a voltage level of the driving voltage may be higher than a voltage level of the common voltage.

In an embodiment, at least a portion of the semiconductor substrate contacting the source region and the drain region may be doped with an n-type impurity.

In an embodiment, the source region and the drain region may be doped with p-type impurities, respectively.

In an embodiment, the pixel may further include a first switching transistor including a first source electrode connected to a data line, a first gate electrode connected to a first gate signal line, and a first drain electrode connected to a first node, a second switching transistor including a second source electrode connected to the drain region of the driving transistor, a second gate electrode connected to an emission control line, and a second drain electrode connected to a second node, a third switching transistor including a third source electrode connected to an initialization voltage line, a third gate electrode connected to a second gate signal line, and a third drain electrode connected to the second node and a storage capacitor connected between the first node and the driving voltage line. The gate electrode of the driving transistor may be connected to the first node and the anode electrode may be connected to the second node.

In an embodiment, the pixel may further include a first switching transistor including a first source electrode connected to a data line, a first gate electrode connected to a first gate signal line, and a first drain electrode connected to a first node, a second switching transistor including a second source electrode connected to the first node, a second gate electrode connected to a second gate signal line, and a second drain electrode connected to a second node, a third switching transistor including a third source electrode connected to the second node, a third gate electrode connected to a first emission control line, and a third drain electrode connected to a third node, a fourth switching transistor including a fourth source electrode connected to an initialization voltage line, a fourth gate electrode connected to a third gate signal line, and a fourth drain electrode connected to the third node, a fifth switching transistor including a fifth source electrode connected to the driving voltage line, a fifth gate electrode connected to a second emission control line, and a fifth drain electrode connected to the source region of the driving transistor, a first capacitor connected between the first node and the first switching transistor, and a second capacitor connected between the first node and the driving voltage line. The gate electrode of the driving transistor may be connected to the first node and the anode electrode may be connected to the third node.

In an embodiment, the pixel may further include a first switching transistor including a first source electrode connected to a data line, a first gate electrode connected to a first gate signal line, and a first drain electrode connected to a third node, a second switching transistor including a second source electrode connected to a first node, a second gate electrode to a second gate signal line, and a second drain electrode to a second node, a third switching transistor including a third source electrode connected to the second node, a third gate electrode connected to an emission control line, and a third drain electrode connected to a fourth node, a fourth switching transistor including a fourth source electrode connected to an initialization voltage line, a fourth gate electrode connected to a third gate signal line, and a fourth drain electrode connected to the fourth node, a fifth switching transistor including a fifth source electrode connected to a reference voltage line, a fifth gate electrode connected to a fourth gate signal line, and a fifth drain electrode connected to the third node, a sixth switching transistor including a sixth source electrode connected to the reference voltage line, a sixth gate electrode connected a fifth gate signal line, and a sixth drain electrode connected to the first node, and a storage capacitor connected between the first node and the third node. The gate electrode of the driving transistor may be connected to the first node and the anode electrode may be connected to the fourth node.

A pixel according to embodiments of the present disclosure includes a driving transistor including: a source region electrically connected to a driving voltage line, which receives a driving voltage and disposed in one side of a semiconductor substrate, a drain region disposed in (or on) the other side of the semiconductor substrate, a channel region disposed in a portion of the semiconductor substrate between the source region and the drain region and having an asymmetrical shape with respect to a center of the channel region in a plan view, an insulating layer disposed on the channel region, and a gate electrode disposed on the insulating layer and overlapping the channel region in the plan view, where the driving transistor is configured to generate a driving current, and a light-emitting element, which generates light based on the driving current and including an anode electrode and a cathode electrode.

In an embodiment, a resistance may be formed between the source region and the gate electrode by the asymmetrical shape of the channel region.

In an embodiment, the asymmetrical shape of the channel region may be an L-shape in the plan view.

In an embodiment, the channel region may include a first region adjacent to the source region and a second region adjacent to the drain region, and an area of the first region may be smaller than an area of the second region.

An electronic device according to embodiments of the present disclosure includes a display device including: a display panel including a plurality of pixels, a data driver, which provides a data voltage to the pixels, a gate driver, which provides a gate signal to the pixels, an emission driver, which provides an emission control signal to the pixels, a controller, which controls the data driver, the gate driver, and the emission driver, and receives an input image data and a control signal, and a processor, which provides the input image data and the control signal to the controller. Each of the pixels includes a driving transistor including: a source region electrically connected to a driving voltage line, which receives a driving voltage and disposed in one side of a semiconductor substrate, a drain region disposed in (or on) the other side of the semiconductor substrate, a channel region disposed in a portion of the semiconductor substrate between the source region and the drain region, an insulating layer disposed on the channel region, and a gate electrode disposed on the insulating layer and overlapping the channel region in a plan view, wherein the driving transistor is configured to generate a driving current and an offset region is formed between the source region and the channel region in the driving transistor in the plan view, and a light-emitting element, which generates light based on the driving current and including an anode electrode and a cathode electrode.

In an embodiment, a resistance may be formed by the offset region between the source region and the gate electrode.

In an embodiment, the gate electrode may partially overlap the channel region and does not overlap the source region in the plan view.

In an embodiment, a shortest length of the offset region may be about 1.7 to about 10 times a thickness of the insulating layer.

In an embodiment, a common voltage line, which receives a common voltage may be connected to the cathode electrode, and a voltage level of the driving voltage may be higher than a voltage level of the common voltage.

In an embodiment, at least a portion of the semiconductor substrate contacting the source region and the drain region may be doped with n-type impurities.

In embodiments of the present disclosure, an offset region may be formed between a source region and a channel region of a driving transistor included in each pixel. Alternatively, the channel region of the driving transistor may have an asymmetrical shape with respect to the center of the channel region. In this case, a resistance may be formed between the source region and the gate electrode by the offset region or the asymmetrical shape of the channel region. Accordingly, the driving transistor may secure a sufficient data range. In addition, if a display device has a high resolution, the integration density may be effectively improved. Accordingly, the short channel effect may not occur, and the image quality characteristics of the display device may not be deteriorated.

A pixel according to embodiments may include a driving transistor, which includes a source region electrically connected to a driving voltage line, which receives a driving voltage and disposed in one side of a semiconductor substrate; a drain region disposed in an opposite side of the semiconductor substrate; a channel region disposed in a portion of the semiconductor substrate between the source region and the drain region; an insulating layer disposed on the channel region; and a gate electrode disposed on the insulating layer and overlapping the channel region in a plan view, wherein the driving transistor may configured to generate a driving current; and a light-emitting element, which generates light based on the driving current and including an anode electrode and a cathode electrode, wherein an offset region may be formed between the source region and the channel region in the driving transistor in the plan view, or wherein the channel region may have an asymmetrical shape with respect to a center of the channel region in a plan view. In both alternatives, a resistance may be formed between the source region and the gate electrode by the offset region or the asymmetrical shape of the channel region.

BRIEF DESCRIPTION OF THE DRAWINGS

Illustrative, non-limiting embodiments will be more clearly understood from the following detailed description in conjunction with the accompanying drawings.

FIG. 1 is a block diagram schematically illustrating a display device according to embodiments of the present disclosure.

FIG. 2 is a circuit diagram illustrating an example of a circuit structure of one pixel of the display device of FIG. 1.

FIG. 3 is a cross-sectional view schematically illustrating a display panel and an encapsulation substrate of FIG. 1.

FIG. 4 is a plan view illustrating an example of a driving transistor included in a pixel driving circuit part of FIG. 3.

FIG. 5 is a cross-sectional view taken along line I-I' of FIG. 4.

FIG. 6 is a graph for explaining the change in brightness according to data voltage in Comparative Example and Embodiment.

FIG. 7 is a graph for explaining a saturation region of the driving transistor of FIGS. 4 and 5.

FIG. 8 is a circuit diagram illustrating another example of a circuit structure of one pixel of the display device of FIG. 1.

FIG. 9 is a circuit diagram illustrating still another example of a circuit structure of one pixel of the display device of FIG. 1.

FIG. 10 is a plan view illustrating another example of a driving transistor included in a pixel driving circuit part of FIG. 3.

FIG. 11 is a block diagram illustrating an electronic device according to embodiments of the present disclosure.

FIG. 12 is a schematic diagram illustrating an electronic device according to various embodiments.

DETAILED DESCRIPTION

It will be understood that when an element is referred to as being "on" another element, it can be directly on the other element or intervening elements may be present therebetween. In contrast, when an element is referred to as being "directly on" another element, there are no intervening elements present.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Hereinafter, embodiments of the present disclosure will be explained in detail with reference to the accompanying drawings. The same reference numerals are used for the same components in the drawings, and redundant descriptions of the same components will be omitted.

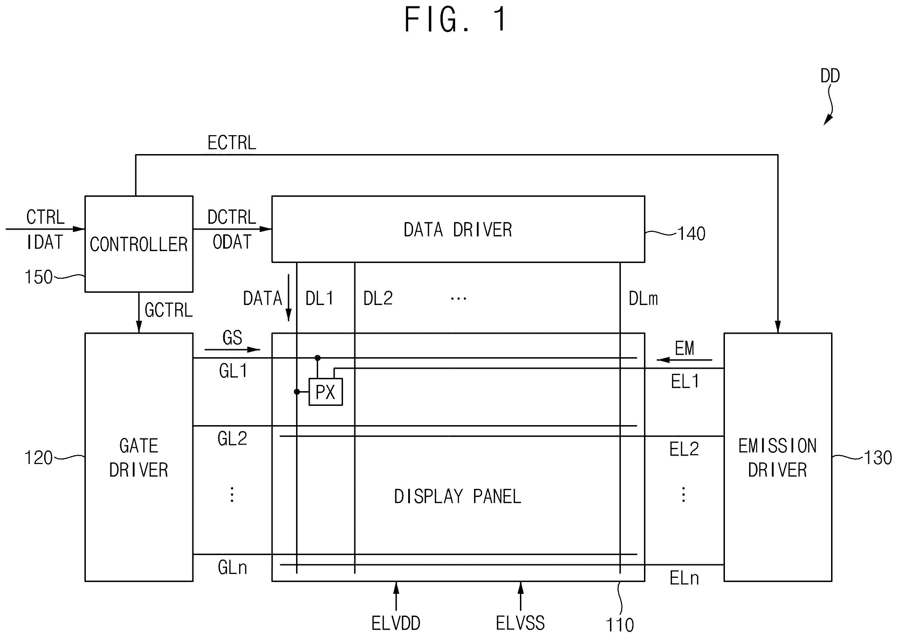

FIG. 1 is a block diagram schematically illustrating a display device according to embodiments of the present disclosure.

Referring to FIG. 1, a display device DD according to embodiments of the present disclosure may include a display panel 110, a gate driver 120, an emission driver 130, a data driver 140, and a controller 150.

The display panel 110 may include a plurality of gate signal lines GL1 to GLn, a plurality of data lines DL1 to DLm, a plurality of emission control lines EL1 to ELn, and a plurality of pixels PX (where n and m are integers greater than or equal to 2). The gate signal lines GL1 to GLn, the emission control lines EL1 to ELn, and the data lines DL1 to DLm may be electrically connected to the pixels PX. The gate signal lines GL1 to GLn may receive a gate signal GS, the emission control lines EL1 to ELn may receive an emission control signal EM, and the data lines DL1 to DLm may receive a data voltage DATA.

Each of the gate signal lines GL1 to GLn may extend in a first direction (e.g., a row direction). Each of the emission control lines EL1 to ELn may extend in the first direction. Each of the data lines DL1 to DLm may extend in a second direction (e.g., a column direction) intersecting the first direction. The gate signal lines GL1 to GLn, the emission control lines EL1 to ELn, and the data lines DL1 to DLm may be insulated from each other. The pixels PX may be arranged in an area where the gate signal lines GL1 to GLn (or the emission control lines EL1 to ELn) and the data lines DL1 to DLm intersect.

In an embodiment, each of the pixels PX may include a switching transistor, which provides the data voltage DATA in response to the gate signal GS, a storage capacitor, which stores the data voltage DATA provided by the switching transistor, a driving transistor generating a driving current based on the data voltage DATA stored in the storage capacitor, and a light-emitting element, which emits light based on the driving current generated by the driving transistor. For example, the light-emitting element may include a light-emitting diode (LED), an organic light-emitting diode (OLED), or a quantum dot (QD) light-emitting element.

The pixels PX may receive a driving voltage ELVDD and a common voltage ELVSS. The pixels PX may receive the data voltage DATA in response to the gate signal GS and the emission control signal EM, and may generate light having a grayscale corresponding to the data voltage DATA by using the driving voltage ELVDD and the common voltage ELVSS.

The gate driver 120 may provide the gate signals GS to the pixels PX through the gate signal lines GL1 to GLn based on a gate control signal GCTRL received from the controller 150. In an embodiment, the gate driver 120 may sequentially provide the gate signals GS to the pixels PX in units of rows. In addition, the gate control signal GCTRL may include a gate start signal, a gate clock signal, and the like, but embodiments of the present disclosure are not necessarily limited thereto. For example, the gate driver 120 may be integrated or formed in a peripheral portion of the display panel 110. Alternatively, the gate driver 120 may be implemented with one or more integrated circuits (IC).

The emission driver 130 may provide the emission control signals EM to the pixels PX through the emission control lines EL1 to ELn based on an emission control signal ECTRL received from the controller 150. In an embodiment, the emission driver 130 may sequentially provide the emission control signals EM to the pixels PX in units of rows. In addition, the emission control signal ECTRL may include an emission start signal, an emission clock signal, and the like, but embodiments of the present invention are not necessarily limited thereto. For example, the emission driver 130 may be integrated or formed in a peripheral portion of the display panel 110. Alternatively, the emission driver 130 may be implemented with one or more integrated circuits (IC).

The data driver 140 may receive a data control signal DCTRL and an output image data ODAT from the controller 150, and provide the data voltages DATA to the pixels PX through the data lines DL1 to DLm based on the data control signal DCTRL and the output image data ODAT. In addition, the data control signal DCTRL may include an output data enable signal, a horizontal start signal, a load signal, and the like, but embodiments of the present disclosure are not necessarily limited thereto. For example, the data driver 140 may be implemented as a single integrated circuit, and the integrated circuit may be referred to as a timing controller embedded data driver ("TED"). Alternatively, the data driver 140 may be implemented as separate integrated circuits.

The controller 150 may receive an input image data IDAT and a control signal CTRL from an external host processor. For example, the controller 150 may be a timing controller, and the host processor may be an application processor (AP), a graphic processing unit (GPU), or a graphic card. In an embodiment, the input image data IDAT may be RGB image data including red image data, green image data, and blue image data. In addition, the control signal CTRL may include a vertical synchronization signal, a horizontal synchronization signal, an input data enable signal, a master clock signal, and the like, but embodiments of the present disclosure are not necessarily limited thereto.

The controller 150 may generate the gate control signal GCTRL, the emission control signal ECTRL, the data control signal DCTRL, and the output image data ODAT based on the input image data IDAT and the control signal CTRL. The controller 150 may control the operation of the gate driver 120 by providing the gate control signal GCTRL to the emission driver 130. The controller 150 may control the operation of the emission driver 130 by providing the emission control signal ECTRL to the emission driver 130. In addition, the controller 150 may control the operation of the data driver 140 by providing the output image data ODAT and the data control signal DCTRL to the data driver 140.

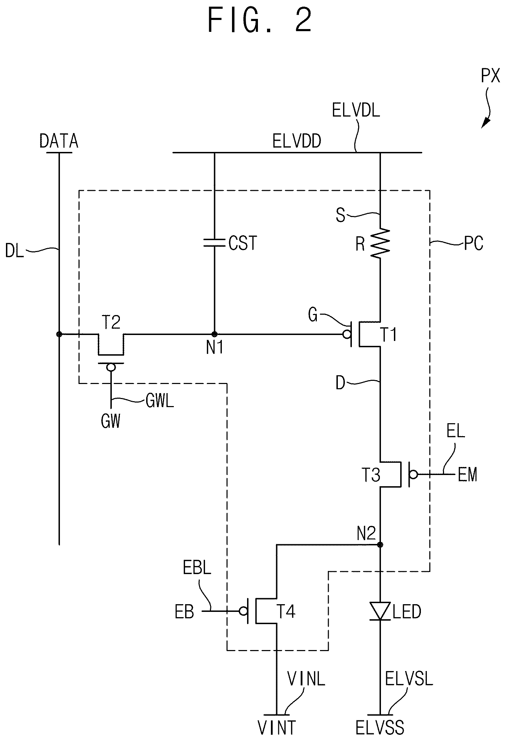

FIG. 2 is a circuit diagram illustrating an example of a circuit structure of one pixel of FIG. 1.

Referring to FIG. 2, each pixel PX may include a pixel driving circuit part PC and a light-emitting element LED electrically connected to the pixel driving circuit part PC. The pixel driving circuit part PC may generate a driving current, and the light-emitting element LED may generate light based on the driving current.

In an embodiment, the pixel driving circuit part PC may include a first transistor T1, a second transistor T2, a third transistor T3, a fourth transistor T4, and a storage capacitor CST.

In an embodiment, the first transistor T1, the second transistor T2, the third transistor T3, and the fourth transistor T4 may all be PMOS transistors. However, embodiments of the present disclosure are not necessarily limited thereto, and some of the first transistor T1, the second transistor T2, the third transistor T3, and the fourth transistor T4 may be PMOS transistors, and the rest may be NMOS transistors.

The first transistor T1 may include a gate electrode G, a source electrode S, and a drain electrode D. The gate electrode G of the first transistor T1 may be connected to a first node N1. The source electrode S of the first transistor T1 may be electrically connected to a driving voltage line ELVDL, which receives the driving voltage ELVDD. The drain electrode D of the first transistor T1 may be connected to the third transistor T3. The first transistor T1 may provide the driving current to the light-emitting element LED. The first transistor T1 may be referred to as a "driving transistor".

In an embodiment, the pixel driving circuit part PC may further include a resistance R connected between the source electrode S of the first transistor T1 and the driving voltage line ELVDL. Due to the resistance R, the first transistor T1 may secure a sufficient data range. Accordingly, the driving characteristics of the first transistor T1 may be improved.

The second transistor T2 may include a gate electrode, a source electrode, and a drain electrode. A first gate signal line GWL, which receives a first gate signal GW may be connected to the gate electrode of the second transistor T2. A data line DL, which receives the data voltage DATA may be connected to the source electrode of the second transistor T2. The drain electrode of the second transistor T2 may be connected to a first node N1.

The second transistor T2 may be turned on or off in response to the first gate signal GW. For example, if the first gate signal GW has an activation level, the second transistor T2 may be turned on. In this case, the second transistor T2 may provide the data voltage DATA to the first node N1. Conversely, if the first gate signal GW has an inactivation level, the second transistor T2 may be turned off. In this case, the second transistor T2 may block the supply of the data voltage DATA.

The third transistor T3 may include a gate electrode, a source electrode, and a drain electrode. The gate electrode of the third transistor T3 may be connected to an emission control line EL, which receives the emission control signal EM. The source electrode of the third transistor T3 may be connected to the first transistor T1. The drain electrode of the third transistor T3 may be connected to a second node N2.

The third transistor T3 may be turned on or off in response to the light emission control signal EM. For example, if the emission control signal EM has an activation level, the third transistor T3 may be turned on. In this case, the third transistor T3 may provide the driving current generated by the first transistor T1 to the anode electrode of the light-emitting element LED. Conversely, if the light emission control signal EM has an inactivation level, the third transistor T3 may be turned off. In this case, the third transistor T3 may block the supply of the driving current generated by the first transistor T1.

The fourth transistor T4 may include a gate electrode, a source electrode, and a drain electrode. A second gate signal line EBL, which receives a second gate signal EB may be connected to the gate electrode of the fourth transistor T4. An initialization voltage line VINL, which receives an initialization voltage VINT may be connected to the source electrode of the fourth transistor T4. The drain electrode of the fourth transistor T4 may be connected to the second node N2.

The fourth transistor T4 may be turned on or off in response to the second gate signal EB. For example, if the second gate signal EB has an activation level, the fourth transistor T4 may be turned on. In this case, the fourth transistor T4 may provide the initialization voltage VINT to the second node N2. Conversely, when the second gate signal EB has an inactivation level, the fourth transistor T4 may be turned off. In this case, the fourth transistor T4 may block the supply of the initialization voltage VINT.

In this specification, each of the second transistor T2, the third transistor T3, and the fourth transistor T4 may be referred to as a "switching transistor".

The storage capacitor CST may include a first electrode and a second electrode. The driving voltage line ELVDL may be connected to the first electrode of the storage capacitor CST. The second electrode of the storage capacitor CST may be connected to the first node N1. That is, the storage capacitor CST may be connected between the first node N1 and the driving voltage line ELVDL.

The light-emitting element LED may include an anode electrode and a cathode electrode. The anode electrode of the light-emitting element LED may be connected to the second node N2. A common voltage line ELVSL, which receives the common voltage ELVSS may be connected to the cathode electrode of the light-emitting element LED. The common voltage ELVSS may have a voltage level lower than the driving voltage ELVDD.

Although FIG. 2 illustrates that one pixel driving circuit part PC includes four transistors and one capacitor, embodiments of the present disclosure are not necessarily limited thereto.

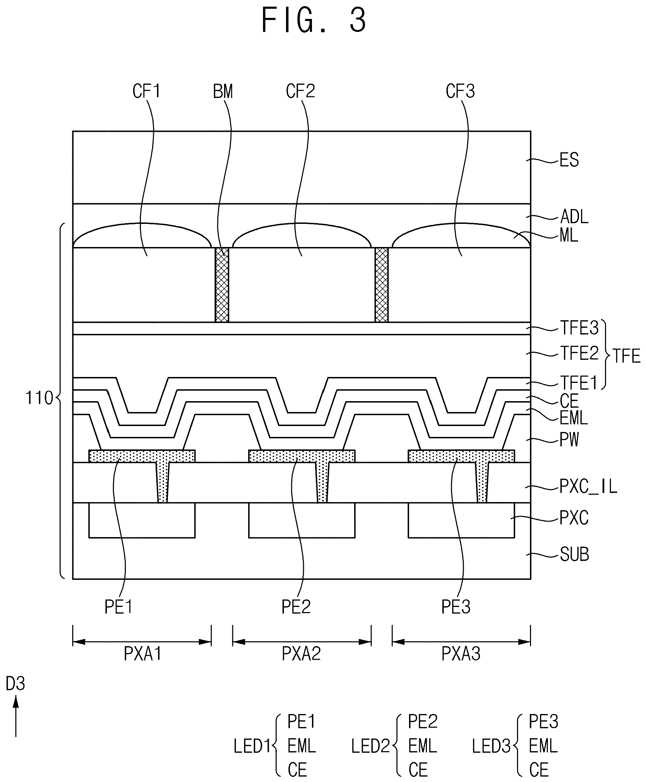

FIG. 3 is a cross-sectional view schematically illustrating a display panel and an encapsulation substrate of FIG. 1.

Referring to FIGS. 1 and 3, the display device DD according to embodiments of the present disclosure may further include an encapsulation substrate ES disposed on the display panel DP. The display panel DP may include a substrate SUB, a plurality of pixel driving circuit parts PXC, a circuit insulating layer PXC_IL, first, second, and third light-emitting elements LED1, LED2, and LED3, a partition wall PW, an encapsulation layer TFE, first, second, and third color filter layers CF1, CF2, and CF3, a light-blocking layer BM, and a lens layer.

Here, the first light-emitting element LED1 may include a first pixel electrode PE1, a light-emitting layer EML, and a common electrode CE, the second light-emitting element LED2 may include a second pixel electrode PE2, the light-emitting layer EML, and the common electrode CE, and the third light-emitting element LED3 may include a third pixel electrode PE3, the light-emitting layer EML, and the common electrode CE. The first light-emitting element LED1 may be disposed in a first pixel area PXA1, the second light-emitting element LED2 may be disposed in a second pixel area PXA2, and the third light-emitting element LED3 may be disposed in a third pixel area PXA3.

In an embodiment, the substrate SUB may include a silicon wafer substrate formed using a semiconductor process. The substrate SUB may be a support member for supporting other components of the display device DD. For example, the substrate SUB may include a semiconductor material (e.g., a group IV semiconductor, a group III-V compound semiconductor, a group II-VI compound semiconductor, and the like). However, the embodiments of the present disclosure are not necessarily limited thereto. In this specification, the substrate SUB may be referred to as a "semiconductor substrate".

The pixel driving circuit parts PXC may be disposed in (e.g., in cavities in) the substrate SUB. The pixel driving circuit parts PXC may overlap the first pixel area PXA1, the second pixel area PXA2, and the third pixel area PXA3, respectively. The pixel driving circuit parts PXC may include various driving elements for driving the first, second, and third light-emitting elements LED1, LED2, and LED3, respectively. For example, each of the pixel driving circuit parts PXC may include at least one transistor formed by a semiconductor process and at least one capacitor formed by a semiconductor process. In an embodiment, each of the pixel driving circuit parts PXC may include the transistors T1, T2, T3, and T4 and the storage capacitor CST of the pixel driving circuit part PC of FIG. 2. However, the embodiments of the present disclosure are not necessarily limited thereto.

The circuit insulating layer PXC_IL may be disposed on the pixel driving circuit parts PXC. The circuit insulating layer PXC_IL may prevent contact between the first, second, and third pixel electrodes PE1, PE2, and PE3 and the pixel driving circuit parts PXC. The circuit insulating layer PXC_IL may include an organic material and/or an inorganic material. For example, the circuit insulating layer PXC_IL may include a plurality of layers formed of various insulating materials.

The first, second, and third pixel electrodes PE1, PE2, and PE3 may be disposed on the circuit insulating layer PXC_IL. The first pixel electrode PE1 may overlap the first pixel area PXA1, the second pixel electrode PE2 may overlap the second pixel area PXA2, and the third pixel electrode PE3 may overlap the third pixel area PXA3.

The first pixel electrode PE1 may be electrically connected to the pixel driving circuit part PXC through a contact hole penetrating the circuit insulating layer PXC_IL in the first pixel area PXA1, the second pixel electrode PE2 may be electrically connected to the pixel driving circuit part PXC through a contact hole penetrating the circuit insulating layer PXC_IL in the second pixel area PXA2, and the third pixel electrode PE3 may be electrically connected to the pixel driving circuit part PXC through a contact hole penetrating the circuit insulating layer PXC_IL in the third pixel area PXA3.

In FIG. 3, for convenience of explanation, the first, second, and third pixel electrodes PE1, PE2, and PE3 are illustrated as being directly connected to the pixel driving circuit part PXC, respectively. However, the first, second, and third pixel electrodes PE1, PE2, and PE3 may be electrically connected to the pixel driving circuit part PXC through at least one conductive pattern, respectively.

The first, second, and third pixel electrodes PE1, PE2, and PE3 may include a metal, an alloy, a metal nitride, a conductive metal oxide, a transparent conductive material, and the like. The first, second, and third pixel electrodes PE1, PE2, and PE3 may each include the same material and may be formed through the same process. For example, each of the first, second, and third pixel electrodes PE1, PE2, and PE3 may have a multilayer structure including ITO/Ag/ITO. However, the embodiments of the present disclosure are not limited thereto. Each of the first, second, and third pixel electrodes PE1, PE2, and PE3 may be an anode electrode. Each of the first, second, and third pixel electrodes PE1, PE2, and PE3 may be a reflective electrode. However, the embodiments of the present disclosure are not limited thereto.

The partition wall PW may be disposed on the circuit insulating layer PXC_IL. The partition wall PW may cover an edge of each of the first, second, and third pixel electrodes PE1, PE2, and PE3. In addition, the partition wall PW may expose at least a portion of an upper surface of each of the first, second, and third pixel electrodes PE1, PE2, and PE3. For example, the partition wall PW may include an inorganic material such as silicon oxide, silicon nitride, silicon oxynitride, and the like. These may be used alone or in combination with each other. Alternatively, the partition wall PW may include an organic material. In an embodiment, the partition wall PW may have a multilayer structure, but embodiments of the present disclosure are not necessarily limited thereto.

The light-emitting layer EML may be disposed on the first, second, and third pixel electrodes PE1, PE2, and PE3 and the partition wall PW. The light-emitting layer EML may be a common layer formed commonly in the first, second, and third pixel areas PXA1, PXA2, and PXA3. That is, the light-emitting layer EML may extend continuously throughout the first, second, and third pixel areas PXA1, PXA2, and PXA3. For example, the light-emitting layer EML may include a hole injection layer, a hole transport layer, an organic light-emitting layer, an electron injection layer, an electron transport layer, and the like. In an embodiment, the organic light-emitting layer may include a light-emitting material, which emits white light. For example, the white light may be a mixture of blue light, green light, and red light. Alternatively, the white light may be a mixture of blue light and yellow light.

However, the embodiments of the present disclosure are not necessarily limited thereto, and the light-emitting layer EML may include a first light-emitting layer overlapping the first pixel area PXA1 and including a light-emitting material, which emits red light, a second light-emitting layer overlapping the second pixel area PXA2 and including a light-emitting material, which emits green light, and a third light-emitting layer overlapping the third pixel area PXA3 and including a light-emitting material, which emits blue light. In this case, the first, second, and third light-emitting layers may be separated from each other, and the first, second, and third color filter layers CF1, CF2, and CF3 and the light-blocking layer BM may be omitted.

The common electrode CE may be disposed on the light-emitting layer EML. The common electrode CE may be a common layer formed commonly in the first, second, and third pixel areas PXA1, PXA2, and PXA3. That is, the common electrode CE may extend continuously throughout the first, second, and third pixel areas PXA1, PXA2, and PXA3. For example, the common electrode CE may include a metal, an alloy, a metal nitride, a conductive metal oxide, a transparent conductive material, and the like. These may be used alone or in combination with each other. The common electrode CE may be a cathode electrode. The common electrode CE may be a transmissive or semi-transmissive electrode.

Accordingly, the first pixel electrode PE1, the light-emitting layer EML, and the common electrode CE may form the first light-emitting element LED1 in the first pixel area PXA1, the second pixel electrode PE2, the light-emitting layer EML, and the common electrode CE may form the second light-emitting element LED2 in the second pixel area PXA2, and the third pixel electrode PE3, the light-emitting layer EML, and the common electrode CE may form the third light-emitting element LED3 in the third pixel area PXA3.

The encapsulation layer TFE may be disposed on the common electrode (CE). The encapsulation layer TFE may extend continuously throughout the first, second, and third pixel areas PXA1, PXA2, and PXA3. The encapsulation layer TFE may prevent impurities, moisture, etc. from penetrating into the first, second, and third light-emitting elements LED1, LED2, and LED3 from the outside.

The encapsulation layer TFE may include at least one inorganic layer and at least one organic layer. For example, the encapsulation layer TFE may include a first inorganic encapsulation layer TFE1, an organic encapsulation layer TFE2 disposed on the first inorganic encapsulation layer TFE1, and a second inorganic encapsulation layer TFE3 disposed on the organic encapsulation layer TFE2. The organic encapsulation layer TFE2 may have a substantially flat upper surface.

For example, the first and third inorganic encapsulation layers TFE1 and TFE3 may include silicon oxide, silicon nitride, silicon oxynitride, and the like. These may be used alone or in combination with each other. The organic encapsulation layer TFE2 may include a polymer cured material such as polyacrylate and the like.

The first, second, and third color filter layers CF1, CF2, and CF3 may be disposed on the encapsulation layer TFE. The first color filter layer CF1 may overlap the first pixel area PXA1, the second color filter layer CF2 may overlap the second pixel area PXA2, and the third color filter layer CF3 may overlap the third pixel area PXA3. Each of the first, second, and third color filter layers CF1, CF2, and CF3 may selectively transmit only light of a specific wavelength and absorb light of the remaining wavelengths. For example, red light may be transmitted through the first color filter layer CF1, green light may be transmitted through the second color filter layer CF2, and blue light may be transmitted through the third color filter layer CF3. Accordingly, the first pixel area PXA1 may emit red light, the second pixel area PXA2 may emit green light, and the third pixel area PXA3 may emit blue light. However, the embodiments of the present disclosure are not necessarily limited thereto.

The light-blocking layer BM may be disposed on the encapsulation layer TFE. The light-blocking layer BM may be disposed between the first, second, and third color filter layers CF1, CF2, and CF3. That is, the light-blocking layer BM may not overlap the first, second, and third pixel areas PXA1, PXA2, and PXA3. The light-blocking layer BM may block light incident on the light-blocking layer BM. Accordingly, the light-blocking layer BM may prevent color mixing between the first, second, and third pixel areas PXA1, PXA2, and PXA3. For example, the light-blocking layer BM may include an organic material and/or an inorganic material containing a black pigment, a black dye, and the like.

The lens layer may be disposed on the first, second, and third color filter layers CF1, CF2, and CF3 and the light-blocking layer BM. The lens layer may include a plurality of micro lenses ML. The micro lenses ML may improve light extraction efficiency. The micro lenses ML may overlap the first, second, and third pixel areas PXA1, PXA2, and PXA3, respectively. The micro lenses ML may have a selected refractive index with respect to visible light. For example, the micro lenses ML may have a refractive index of about 1.5 or more to about 1.7 or less for visible light. For example, a lower boundary for the refractive index may be 1.5, 1.55, 1.6 or 1.65. An upper boundary for the refractive index may be 1.7, 1.65, 1.6 or 1.55. However, the embodiments of the present disclosure are not necessarily limited thereto. For example, each of the micro lenses ML may have a convex cross-sectional shape.

The encapsulation substrate ES may be disposed on the lens layer. The encapsulation substrate ES may be attached to the display panel 110 through an adhesive layer ADL. The encapsulation substrate ES may protect the display panel 110 from moisture or gas inflow. The encapsulation substrate ES may include a transparent insulating substrate. For example, the encapsulation substrate ES may include glass. For example, the adhesive layer ADL may include an optical clear adhesive (OCA), a pressure sensitive adhesive (PSA), a photocurable resin, a thermocurable resin, or the like.

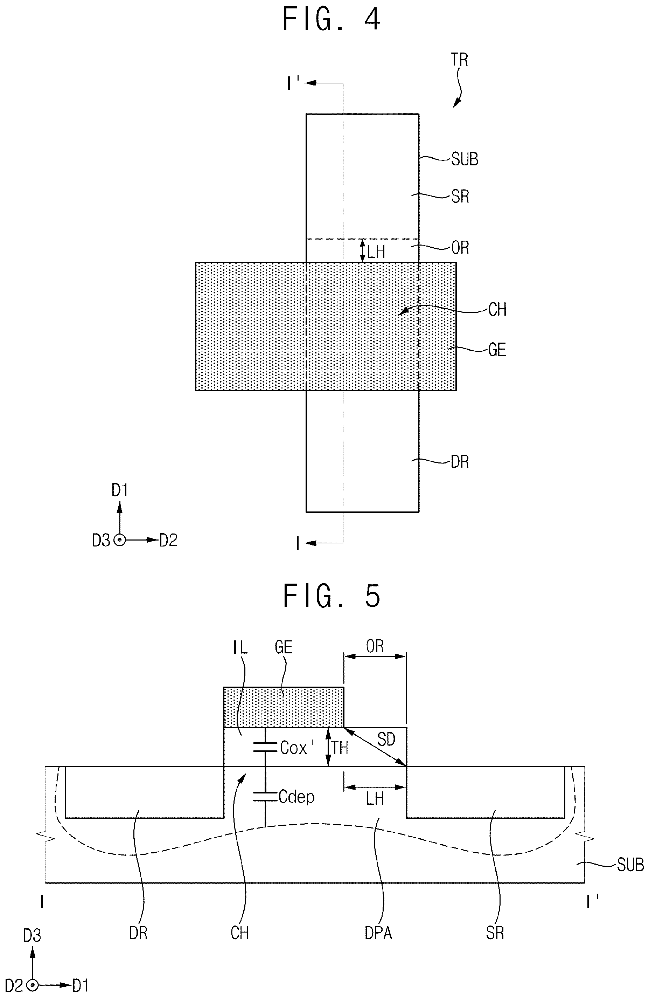

FIG. 4 is a plan view illustrating an example of a driving transistor included in a pixel driving circuit part of FIG. 3. FIG. 5 is a cross-sectional view taken along line I-I' of FIG. 4. As used herein, the plan view is a view in a thickness direction (i.e., third direction D3) of the semiconductor substrate.

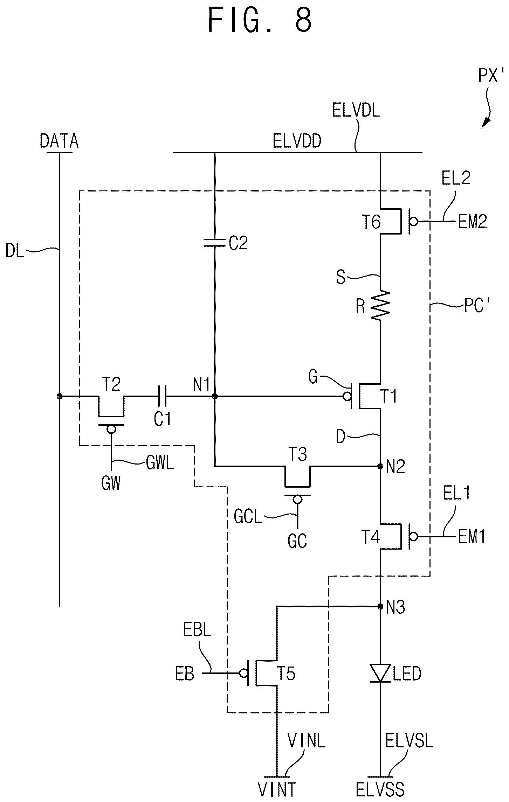

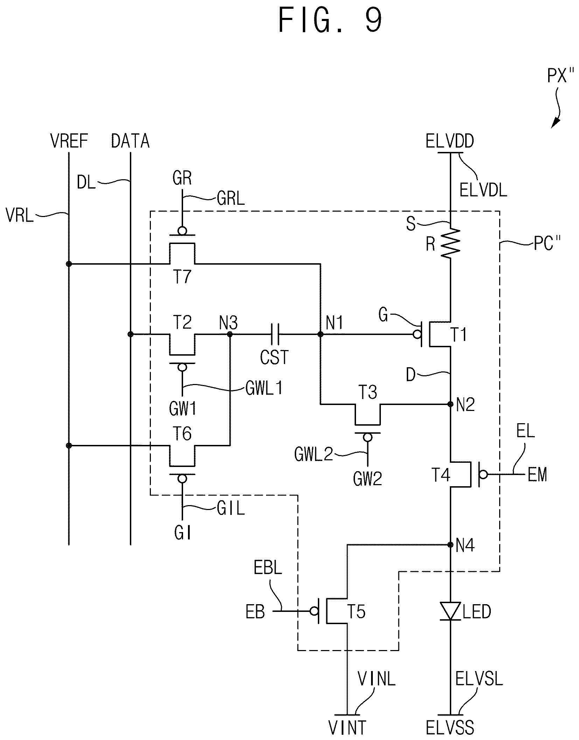

Referring to FIGS. 3, 4, and 5, as described above, the pixel driving circuit part PXC may include at least one transistor (i.e., MOSFET) formed through a semiconductor process. For example, the transistor may include at least one switching transistor and a driving transistor. In an embodiment, the pixel driving circuit part PXC may include a driving transistor TR formed through a semiconductor process. The driving transistor TR may correspond to the first transistor T1 illustrated in FIG. 2. Alternatively, the driving transistor TR may correspond to a first transistor T1 illustrated in FIG. 8 or a first transistor T1 illustrated in FIG. 9 described below.

The driving transistor TR may include a source region SR, a drain region DR, a channel region CH, an insulating layer IL, and a gate electrode GE.

The substrate SUB may include a semiconductor material. In an embodiment, the substrate SUB may be an n-type semiconductor substrate doped with n-type impurities or a p-type semiconductor substrate doped with p-type impurities. The substrate SUB may extend in the first direction D1.

The source region SR and the drain region DR may be disposed in the substrate SUB. Specifically, the source region SR may be disposed in (or on) one side in the substrate SUB, and the drain region DR may be disposed in (or on) the other side of the substrate SUB, which is opposite to the one side in the first direction D1. The source region SR may correspond to the source electrode S of FIG. 2, and the drain region DR may correspond to the drain electrode D of FIG. 2. For example, the source region SR and the drain region DR may include the same semiconductor material as the substrate SUB.

The source region SR and the drain region DR may be doped with impurities. Accordingly, the source region SR and the drain region DR may be conductive regions. The doping concentration of each of the source region SR and the drain region DR may be higher than the doping concentration of other parts of the substrate SUB. In an embodiment, the source region SR and the drain region DR may be doped with p-type impurities. However, the embodiments of the present disclosure are not necessarily limited thereto.

At least a portion of the substrate SUB contacting the source region SR and the drain region DR may be doped with an impurity (or with impurities) of an opposite type to impurities of the source region SR and the drain region DR. In an embodiment, if the source region SR and the drain region DR are doped with p-type impurities, at least a portion of the substrate SUB contacting the source region SR and the drain region DR may be doped with an n-type impurity (or with n-type impurities).

The channel region CH may be disposed between the source region SR and the drain region DR in the substrate SUB. For example, the channel region CH may include the same semiconductor material as the substrate SUB. The channel region CH may be a region of the substrate SUB in which a carrier having a charge (e.g., charge carriers) conducts (or conduct) if a voltage (e.g., a negative voltage) is applied to the gate electrode GE.

The above channel region CH may be defined as a current path formed between the source region SR and the drain region DR. For example, if the source region SR and the drain region DR are doped with p-type impurities, the channel region CH may be formed if a negative voltage is applied to the gate electrode GE and may transmit current through the movement of holes.

A depletion region DPA may be formed in the substrate SUB. For example, if the source region SR and the drain region DR are doped with p-type impurities, the depletion region DPA may be a region where charges are reduced due to the extraction of electrons around the upper surface of the substrate SUB if a negative voltage is applied to the gate electrode GE. The depletion region DPA may be formed by the influence of an electric field, which removes free electrons from the substrate SUB, leaving only fixed positive ions. The size of the depletion region DPA may change depending on the magnitude of the voltage applied to the gate electrode GE.

The insulating layer IL may be disposed on the substrate SUB. Specifically, the insulating layer IL may overlap the channel region CH in a plan view. The insulating layer IL may include silicon oxide (e.g., $SiO_2$), silicon nitride, or an insulating material having a high dielectric constant. The material having the high dielectric constant may denote a dielectric material having a higher dielectric constant than the silicon oxide. For example, the material having the high dielectric constant may include aluminum oxide ($Al_2O_3$), tantalum oxide ($Ta_2O_3$), titanium oxide ($TiO_2$), yttrium oxide ($Y_2O_3$), zirconium oxide ($ZrO_2$), zirconium silicon oxide ($ZrSi_xO_y$), hafnium oxide ($HfO_2$), hafnium silicon oxide ($HfSi_xO_y$), lanthanum oxide ($La_2O_3$), lanthanum aluminum oxide ($LaAl_xO_y$), lanthanum hafnium oxide ($LaHf_xO_y$), hafnium aluminum oxide ($HfAl_xO_y$), praseodymium oxide ($Pr_2O_3$), and the like. These may be used alone or in combination with each other. However, the embodiments of the present disclosure are not necessarily limited thereto.

The gate electrode GE may be disposed on the insulating layer IL, and the gate electrode GE may extend in the second direction D2. Here, the first to third directions D1 to D3 may be perpendicular to one another. The gate electrode GE may overlap the channel region CH in the plan view. In other words, the portion of the substrate SUB overlapping the gate electrode GE may form the channel region CH. The gate electrode GE may include a metal, a metal nitride, and the like. Examples of the metal may include aluminum, tungsten, copper, molybdenum, and the like. Examples of the metal nitride may include titanium nitride (TiN), tantalum nitride (TaN), tungsten nitride (WN), and the like. These may be used alone or in combination with each other. Alternatively, the gate electrode GE may include a semiconductor material such as doped polysilicon. In addition, the gate electrode GE may have a single-layer structure or a multi-layer structure including a plurality of layers.

In an embodiment, an offset region OR may be formed between the source region SR and the channel region CH in a plan view, while there is no offset region between the drain region DR and the channel region CG in the plan view. In another embodiment, while there is another offset region between the drain region DR and the channel region CG, a width of the another offset region in the first direction D1 is smaller than a width of the offset region OR between the source region SR and the channel region CH in the first direction D1. That is, since the gate electrode GE does not overlap the source region SR but partially overlaps the channel region CH and insulating layer IL in the plan view, the offset region OR may be formed between the source region SR and the channel region CH in the plan view. In an embodiment, the offset region OR may be formed from a border of the gate electrode GE facing the source region SR to a border of the source region SR facing the gate electrode GE. By the offset region OR, resistance R may be formed between the source region SR and the gate electrode GE. A width of the gate electrode GE (e.g., in the first direction) may be smaller than a width (e.g., in the first direction) of the insulating layer IL (e.g., when seen in a plan view). The gate electrode GE may thus not cover a part of the insulating layer IL, and in particular a part of the insulating layer IL arranged next to the source region SR. The offset region OR may correspond to the part (or the region) of the insulating layer IL not covered by the gate electrode GE.

A parameter called subthreshold swing (hereinafter, S.S.) may be used to define the relationship between a gate voltage and a drain current if the driving transistor TR operates in a subthreshold region. The subthreshold region may denote a region in which the drain current nonlinearly increases by the gate voltage if the driving transistor TR is not fully turned on. The S.S. value may be defined by Equation 1 below. In addition, referring to Equation 1, the S.S. value may be determined by the ratio of $C_{dep}$ and $C_{ox}$.

[Equation 1]

$$S.S. = \frac{dV_{gs}}{d\log I_{ds}} \propto \left(1 + \frac{C_{dep}}{C_{ox}}\right)$$

Here, $V_{gs}$ is the gate voltage, $I_{ds}$ is the drain current, $C_{dep}$ is the capacitance of the depletion region DPA, and $C_{ox}$ is the capacitance of the insulating layer IL if the offset region OR is not formed.

In addition, if the offset region OR is formed between the source region SR and the channel region CH as illustrated in FIG. 5, the S.S. value may be defined by Equation 2 below.

[Equation 2]

$$S.S. = \frac{dV_{gs}}{d\log I_{ds}} \propto \left(1 + \frac{C_{dep}}{C_{ox'}}\right)$$

Here, $V_{gs}$ is the gate voltage, $I_{ds}$ is the drain current, $C_{dep}$ is the capacitance of the depletion region DPA, and $C_{ox'}$ is the capacitance of the insulating layer IL if the offset region OR is formed.

If the S.S. value decreases, the driving transistor TR may be driven with low power, and the response speed may be improved. On the other hand, if the S.S. value increases, the driving transistor TR may be driven with high power, and the response speed may be reduced. That is, if the S.S. value decreases, the driving characteristics of the driving transistor TR may be improved, and if the S.S. value increases, the driving characteristics of the driving transistor TR may be deteriorated.

In order to improve the driving characteristics of the driving transistor TR, $C_{dep}/C_{ox}$ in Equation 1 may satisfy Equation 3 below, and $C_{dep}/C_{ox'}$ in Equation 2 may satisfy Equation 4 below. In addition, $C_{ox'}$ in Equation 2 may satisfy Equation 5 below.

[Equation 3]

$$\frac{C_{dep}}{C_{ox}} \leq 0.5$$

[Equation 4]

$$2 \leq \frac{C_{dep}}{C_{ox'}} \leq 10$$

[Equation 5]

$$C_{ox'} \propto \frac{TH}{SD}$$

In Equation 5, TH is the thickness of the insulating layer IL (measured in the third direction D3), and SD is the shortest distance between the gate electrode GE and the source region SR. The direction of the shortest distance SD may be a diagonal direction with respect to the first direction D1 and the third direction D3.

The shortest distance SD between the gate electrode GE and the source region SR may satisfy Equation 6 by the Pythagorean theorem.

[Equation 6]

$$SD^2 = TH^2 + LH^2$$

In Equation 6, LH is the shortest length of the offset region OR in a plan view. The shortest length LH may be measured in the first direction D1.

In an embodiment, by combining Equations 3, 4, 5, and 6, Equation 7 below may be derived.

[Equation 7]

$$\sqrt{3} \times TH \leq LH \leq \sqrt{99} \times TH$$

That is, in an embodiment, as in Equation 7, the shortest length LH of the offset region OR in a plan view may be 1.7 times to 10 times a thickness TH of the insulating layer IL. If the shortest length LH of the offset region OR is less than 1.7 times the thickness TH of the insulating layer IL, the data range of the driving transistor TR may not be sufficiently secured. If the shortest length LH of the offset region OR exceeds 10 times the thickness TH of the above insulating layer IL, the driving transistor TR may not operate. In an embodiment, a lower boundary for the shortest length LH of the offset region OR in a plan view may be 1.7 times, 2.5 times or 4 times a thickness TH of the insulating layer IL. An upper boundary for the shortest length LH of the offset region OR in a plan view may be 5 times, 7 times or 10 times a thickness TH of the insulating layer IL.

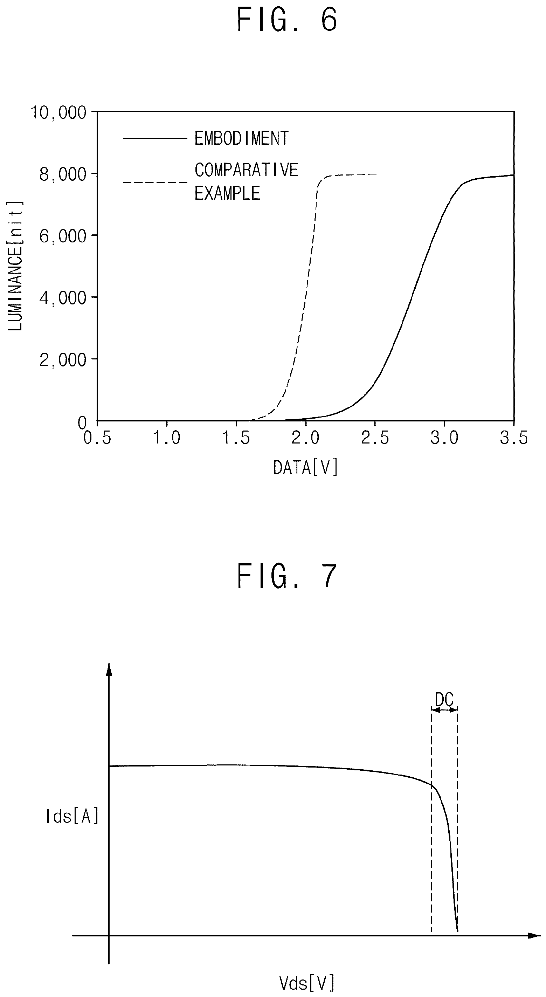

FIG. 6 is a graph for explaining the change in brightness according to data voltage in a Comparative Example and an Embodiment.

Referring to FIGS. 2 and 6, in Embodiment, the pixel driving circuit part PC of each pixel PX may have the circuit structure illustrated in FIG. 2. That is, the pixel driving circuit part PC satisfying Embodiment may include four transistors and one capacitor, and may have a structure in which a resistance is connected to the source electrode of the driving transistor.

In the Comparative Example, a pixel driving circuit part of each pixel may have the same circuit structure as the pixel driving circuit part PC illustrated in FIG. 2, except that no resistance is connected to a source electrode of a driving transistor. That is, the pixel driving circuit part satisfying the Comparative Example may include four transistors and one capacitor.

It can be confirmed that the data range of the driving transistor of the pixel driving circuit part PC satisfying the Embodiment is larger than the data range of the driving transistor of the pixel driving circuit part satisfying the Comparative Example. Here, the data range refers to the range between the data voltage corresponding to the lowest luminance and the data voltage corresponding to the highest luminance.

FIG. 7 is a graph for explaining a saturation region of the driving transistor of FIGS. 4 and 5.

Referring to FIGS. 4, 5, and 7, the operating region of the driving transistor TR may include a saturation region. In the saturation region, the driving transistor TR may be in a fully turned-on state. The saturation region denotes a state in which a drain current $I_{ds}$ no longer significantly increases with an increase in a drain-source voltage $V_{ds}$ during the process in which current flows from the source region SR to the drain region DR. In the saturation region, the driving transistor TR stably maintains the flow of current, and the drain current $I_{ds}$ maintains a constant value even when the drain-source voltage $V_{ds}$ increases.

In the saturation region, there may be a section DC in which the drain current $I_{ds}$ rapidly decreases as the drain-source voltage $V_{ds}$ increases. If the section DC is relatively large, the performance of the driving transistor TR may deteriorate. On the other hand, if the section DC is relatively small, the performance of the driving transistor TR may be stably maintained, and power consumption may also be reduced.

As illustrated in FIG. 2, if the resistance R is connected to the source electrode S of the first transistor T1 (i.e., the driving transistor), the section DC may be relatively small. Similarly, since the resistance R is also connected to the source electrode S of the first transistor T1 to be described with reference to FIGS. 8 and 9, the section DC may be relatively small.

Conversely, an additional transistor may be connected to the source electrode S of the first transistor T1 instead of the resistance R. In this case, the gate electrode of the additional transistor may be connected to the source electrode S of the first transistor T1. In this case, the first transistor T1 may secure a sufficient data range, but the section DC may be relatively large.

FIG. 8 is a circuit diagram illustrating another example of a circuit structure of one pixel of FIG. 1.

Referring to FIG. 8, each pixel PX' may include a pixel driving circuit part PC' and a light-emitting element LED electrically connected to the pixel driving circuit part PC'. The pixel driving circuit part PC' may generate a driving current, and the light-emitting element LED may generate light based on the driving current.

In an embodiment, the pixel driving circuit part PC' may include a first transistor T1, a second transistor T2, a third transistor T3, a fourth transistor T4, a fifth transistor T5, a sixth transistor T6, a first capacitor C1, and a second capacitor C2.

In an embodiment, the first transistor T1, the second transistor T2, the third transistor T3, the fourth transistor T4, the fifth transistor T5, and the sixth transistor T6 may all be PMOS transistors. However, the embodiments of the present disclosure are not necessarily limited thereto, and some of the first transistor T1, the second transistor T2, the third transistor T3, the fourth transistor T4, the fifth transistor T5, and the sixth transistor T6 may be PMOS transistors, and the rest may be NMOS transistors.

The first transistor T1 may include a gate electrode G, a source electrode S, and a drain electrode D. The gate electrode G of the first transistor T1 may be connected to a first node N1. The source electrode S of the first transistor T1 may be electrically connected to a driving voltage line ELVDL, which receives the driving voltage ELVDD. The drain electrode D of the first transistor T1 may be connected to a second node N2. The first transistor T1 may provide the driving current to the light-emitting element LED. The first transistor T1 may be referred to as a driving transistor.

The second transistor T2 may include a gate electrode, a source electrode, and a drain electrode. A first gate signal line GWL, which receives a first gate signal GW may be connected to the gate electrode of the second transistor T2. A data line DL, which receives the data voltage DATA may be connected to the source electrode of the second transistor T2. The drain electrode of the second transistor T2 may be connected to the first capacitor C1.

The second transistor T2 may be turned on or off in response to the first gate signal GW. For example, if the first gate signal GW has an activation level, the second transistor T2 may be turned on. In this case, the second transistor T2 may provide the data voltage DATA to the first capacitor C1. Conversely, if the first gate signal GW has an inactivation level, the second transistor T2 may be turned off. In this case, the second transistor T2 may block the supply of the data voltage DATA.

The third transistor T3 may include a gate electrode, a source electrode, and a drain electrode. A second gate signal line GCL, which receives a second gate signal GC may be connected to the gate electrode of the third transistor T3. The source electrode of the third transistor T3 may be connected to the first node N1. The drain electrode of the third transistor T3 may be connected to the second node N2.

The third transistor T3 may be turned on or off in response to the second gate signal GC. For example, if the second gate signal GC has an activation level, the third transistor T3 may be turned on. In this case, the third transistor T3 may diode-connect the first transistor T1. That is, the third transistor T3 may compensate for the threshold voltage of the first transistor T1. Conversely, if the second gate signal GC has an inactivation level, the third transistor T3 may be turned off. In this case, the first transistor T1 may not be diode-connected.

The fourth transistor T4 may include a gate electrode, a source electrode, and a drain electrode. A first emission control line EL1, which receives a first emission control signal EM1 may be connected to the gate electrode of the fourth transistor T4. The source electrode of the fourth transistor T4 may be connected to the second node N2. The drain electrode of the fourth transistor T4 may be connected to a third node N3.

The fourth transistor T4 may be turned on or off in response to the first emission control signal EM1. For example, if the emission control signal EM1 has an activation level, the fourth transistor T4 may be turned on. In this case, the fourth transistor T4 may provide the driving current generated by the first transistor T1 to the third node N3. Conversely, if the first emission control signal EM1 has an inactivation level, the fourth transistor T4 may be turned off. In this case, the fourth transistor T4 may block the supply of the driving current generated by the first transistor T1.

The fifth transistor T5 may include a gate electrode, a source electrode, and a drain electrode. A third gate signal line EBL, which receives a third gate signal EB may be connected to the gate electrode of the fifth transistor T5. An initialization voltage line VINL, which receives an initialization voltage VINT may be connected to the source electrode of the fifth transistor T5. The drain electrode of the fifth transistor T5 may be connected to the third node N3.

The fifth transistor T5 may be turned on or off in response to the third gate signal EB. For example, if the third gate signal EB has an activation level, the fifth transistor T5 may be turned on. In this case, the fifth transistor T5 may provide the initialization voltage VINT to the third node N3. Conversely, if the third gate signal EB has inactivation level, the fifth transistor T5 may be turned off. In this case, the fifth transistor T5 may block the supply of the initialization voltage VINT.

The sixth transistor T6 may include a gate electrode, a source electrode, and a drain electrode. A second emission control line EL2, which receives a second emission control signal EM2 may be connected to the gate electrode of the sixth transistor T6. A driving voltage line ELVDL, which receives the driving voltage ELVDD may be connected to the source electrode of the sixth transistor T6. The drain electrode of the sixth transistor T6 may be connected to the source electrode S of the first transistor T1.

The sixth transistor T6 may be turned on or off in response to the second emission control signal EM2. For example, if the second emission control signal EM2 has an activation level, the sixth transistor T6 may be turned on. In this case, the sixth transistor T6 may provide the driving voltage ELVDD to the first transistor T1. Conversely, if the second emission control signal EM2 has an inactivation level, the sixth transistor T6 may be turned off. In this case, the sixth transistor T6 may block the supply of the driving voltage ELVDD.

As illustrated in FIG. 8, the first emission control line EL1 connected to the gate electrode of the fourth transistor T4 and the second emission control line EL2 connected to the gate electrode of the sixth transistor T6 may be independent of each other. Alternatively, a single emission control line may be connected to the gate electrode of the fourth transistor T4 and the gate electrode of the sixth transistor T6. In this case, the first emission control signal EM1 may be the same as the second emission control signal EM2.

In this specification, each of the second transistor T2, the third transistor T3, the fourth transistor T4, the fifth transistor T5, and the sixth transistor T6 may be referred to as a "switching transistor".

The first capacitor C1 may include a first electrode and a second electrode. The first electrode of the first capacitor C1 may be connected to the second transistor T2. The second electrode of the first capacitor C1 may be connected to the first node N1. That is, the first capacitor C1 may be connected between the second transistor T2 and the first node N1.

The second capacitor C2 may include a first electrode and a second electrode. The driving voltage line ELVDL may be connected to the first electrode of the second capacitor C2. The second electrode of the second capacitor C2 may be connected to the first node N1. That is, the second capacitor C2 may be connected between the first node N1 and the driving voltage line ELVDL.

In an embodiment, the pixel driving circuit part PC' may further include a resistance R connected between the source electrode S of the first transistor T1 and the sixth transistor T6. Due to the resistance R, the first transistor T1 may secure a sufficient data range. Accordingly, the driving characteristics of the first transistor T1 may be improved.

The light-emitting element LED may include an anode electrode and a cathode electrode. The anode electrode of the light-emitting element LED may be connected to the third node N3. A common voltage line ELVSL, which receives the common voltage ELVSS may be connected to the cathode electrode of the light-emitting element LED. The common voltage ELVSS may have a voltage level lower than the driving voltage ELVDD.

Although FIG. 8 illustrates that one pixel driving circuit part PC' includes six transistors and two capacitors, embodiments of the present disclosure are not necessarily limited thereto.

FIG. 9 is a circuit diagram illustrating still another example of a circuit structure of one pixel of FIG. 1.

Referring to FIG. 9, each pixel PX" may include a pixel driving circuit part PC" and a light-emitting element LED electrically connected to the pixel driving circuit part PC". The pixel driving circuit part PC" may generate a driving current, and the light-emitting element LED may generate light based on the driving current.

In an embodiment, the pixel driving circuit part PC" may include a first transistor T1, a second transistor T2, a third transistor T3, a fourth transistor T4, a fifth transistor T5, a sixth transistor T6, a seventh transistor T7, and a storage capacitor CST.

In an embodiment, the first transistor T1, the second transistor T2, the third transistor T3, the fourth transistor T4, the fifth transistor T5, the sixth transistor T6, and the seventh transistor T7 may all be PMOS transistors. However, the embodiments of the present disclosure are not necessarily limited thereto, and some of the first transistor T1, the second transistor T2, the third transistor T3, the fourth transistor T4, the fifth transistor T5, the sixth transistor T6, and the seventh transistor T7 may be PMOS transistors, and the rest may be NMOS transistors.

The first transistor T1 may include a gate electrode G, a source electrode S, and a drain electrode D. The gate electrode G of the first transistor T1 may be connected to a first node N1. The source electrode S of the first transistor T1 may be electrically connected to a driving voltage line ELVDL, which receives the driving voltage ELVDD. The drain electrode D of the first transistor T1 may be connected to a second node N2. The first transistor T1 may provide the driving current to the light-emitting element LED. The first transistor T1 may be referred to as a driving transistor.

In an embodiment, the pixel driving circuit part PC" may further include a resistance R connected between the source electrode S of the first transistor T1 and the driving voltage line ELVDL. Due to the resistance R, the first transistor T1 may secure a sufficient data range. Accordingly, the driving characteristics of the first transistor T1 may be improved.

The second transistor T2 may include a gate electrode, a source electrode, and a drain electrode. A first-first gate signal line GWL1, which receives a first-first gate signal GW1 may be connected to the gate electrode of the second transistor T2. A data line DL, which receives the data voltage DATA may be connected to the source electrode of the second transistor T2. The drain electrode of the second transistor T2 may be connected to a third node N3.

The second transistor T2 may be turned on or off in response to the first-first gate signal GW1. For example, if the first-first gate signal GW1has an activation level, the second transistor T2 may be turned on. In this case, the second transistor T2 may provide the data voltage DATA to the third node N3. Conversely, if the first-first gate signal GW1 has an inactivation level, the second transistor T2 may be turned off. In this case, the second transistor T2 may block the supply of the data voltage DATA.

The third transistor T3 may include a gate electrode, a source electrode, and a drain electrode. Afirst-second gate signal line GWL2, which receives a first-second gate signal GW2 may be connected to the gate electrode of the third transistor T3. The source electrode of the third transistor T3 may be connected to the first node N1. The drain electrode of the third transistor T3 may be connected to the second node N2. For example, the first-first gate signal GW1 and the first-second gate signal GW2 may be applied at different timings.

The third transistor T3 may be turned on or off in response to the first-second gate signal GW2. For example, if the first-second gate signal GW2 has an activation level, the third transistor T3 may be turned on. In this case, the third transistor T3 may diode-connect the first transistor T1. Conversely, if the first-second gate signal GW2 has an inactivation level, the third transistor T3 may be turned off. In this case, the first transistor T1 may not be diode-connected.

The fourth transistor T4 may include a gate electrode, a source electrode, and a drain electrode. An emission control line EL, which receives an emission control signal EM may be connected to the gate electrode of the fourth transistor T4. The source electrode of the fourth transistor T4 may be connected to the second node N2. The drain electrode of the fourth transistor T4 may be connected to a fourth node N4.

The fourth transistor T4 may be turned on or off in response to the emission control signal EM. For example, if the emission control signal EM has an activation level, the fourth transistor T4 may be turned on. In this case, the fourth transistor T4 may provide the driving current generated by the first transistor T1 to the fourth node N4. Conversely, if the emission control signal EM has an inactivation level, the fourth transistor T4 may be turned off. In this case, the fourth transistor T4 may block the supply of the driving current generated by the first transistor T1.

The fifth transistor T5 may include a gate electrode, a source electrode, and a drain electrode. A second gate signal line EBL, which receives a second gate signal EB may be connected to the gate electrode of the fifth transistor T5. An initialization voltage line VINL, which receives an initialization voltage VINT may be connected to the source electrode of the fifth transistor T5. The drain electrode of the fifth transistor T5 may be connected to the fourth node N4.

The fifth transistor T5 may be turned on or off in response to the second gate signal EB. For example, if the second gate signal EB has an activation level, the fifth transistor T5 may be turned on. In this case, the fifth transistor T5 may provide the initialization voltage VINT to the fourth node N4. Conversely, if the second gate signal EB has an inactivation level, the fifth transistor T5 may be turned off. In this case, the fifth transistor T5 may block the supply of the initialization voltage VINT.

The sixth transistor T6 may include a gate electrode, a source electrode, and a drain electrode. A third gate signal line GIL, which receives a third gate signal GI may be connected to the gate electrode of the sixth transistor T6. A reference voltage line VRL, which receives a reference voltage VREF may be connected to the source electrode of the sixth transistor T6. The drain electrode of the sixth transistor T6 may be connected to the third node N3.

The sixth transistor T6 may be turned on or off in response to the third gate signal GI. For example, if the third gate signal GI has an activation level, the sixth transistor T6 may be turned on. In this case, the sixth transistor T6 may provide the reference voltage VREF to the third node N3. Conversely, if the third gate signal GI has an inactivation level, the sixth transistor T6 may be turned off. In this case, the sixth transistor T6 may block the supply of the reference voltage VREF.

The seventh transistor T7 may include a gate electrode, a source electrode, and a drain electrode. A fourth gate signal line GRL, which receives a fourth gate signal GR may be connected to the gate electrode of the seventh transistor T7. The reference voltage line VRL may be connected to the source electrode of the seventh transistor T7. The drain electrode of the seventh transistor T7 may be connected to the first node N1.

The seventh transistor T7 may be turned on or off in response to the fourth gate signal GR. For example, if the fourth gate signal GR has an activation level, the seventh transistor T7 may be turned on. In this case, the seventh transistor T7 may provide the reference voltage VREF to the first node N1. Conversely, if the fourth gate signal GR has an inactivation level, the seventh transistor T7 may be turned off. In this case, the seventh transistor T7 may block the supply of the reference voltage VREF.

In this specification, each of the second transistor T2, the third transistor T3, the fourth transistor T4, the fifth transistor T5, the sixth transistor T6, and the seventh transistor T7 may be referred to as a "switching transistor".

The storage capacitor CST may include a first electrode and a second electrode. The first electrode of the storage capacitor CST may be connected to the third node N3. The second electrode of the storage capacitor CST may be connected to the first node N1. That is, the storage capacitor CST may be connected between the first node N1 and the third node N3.

The light-emitting element LED may include an anode electrode and a cathode electrode. The anode electrode of the light-emitting element LED may be connected to the fourth node N4. A common voltage line ELVSL, which receives the common voltage ELVSS may be connected to the cathode electrode of the light-emitting element LED. The common voltage ELVSS may have a voltage level lower than the driving voltage ELVDD.

Although FIG. 9 illustrates that one pixel driving circuit part PC'' includes seven transistors and one capacitor, embodiments of the present disclosure are not necessarily limited thereto.

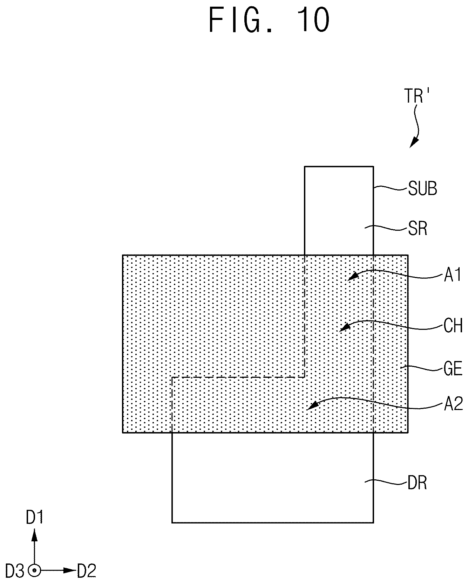

FIG. 10 is a plan view illustrating another example of a driving transistor included in a pixel driving circuit part of FIG. 3.

Referring to FIGS. 3 and 10, as described above, the pixel driving circuit part PXC may include at least one transistor (i.e., MOSFET) formed through a semiconductor process. For example, the transistor may include at least one switching transistor and a driving transistor. In an embodiment, the pixel driving circuit part PXC may include a driving transistor TR' formed through a semiconductor process.

The driving transistor TR' may correspond to the first transistor T1 illustrated in FIG. 2, the first transistor T1 illustrated in FIG. 8, or the first transistor T1 illustrated in FIG. 9.

The driving transistor TR' may include a source region SR, a drain region DR, a channel region CH, an insulating layer, and a gate electrode GE.

The substrate SUB may include a semiconductor material. In an embodiment, the substrate SUB may be an n-type silicon substrate doped with an n-type impurity. However, the embodiments of the present disclosure are not necessarily limited thereto.

The source region SR and the drain region DR may be arranged inside the substrate SUB. Specifically, the source region SR may be disposed in one side inside the substrate SUB, and the drain region DR may be disposed in (or on) the other side inside the substrate SUB.

In an embodiment, the source region SR and the drain region DR may be doped with p-type impurities. However, the embodiments of the present disclosure are not necessarily limited thereto. The channel region CH may be disposed between the source region SR and the drain region DR in the substrate SUB.

The insulating layer may be disposed on the substrate SUB. Specifically, the insulating layer may overlap the channel region CH in a plan view. The insulating layer may be the same as the insulating layer IL of FIG. 5. The gate electrode GE may be disposed on the insulating layer. The gate electrode GE may overlap the channel region CH in the plan view. The driving transistor TR' may not have an offset region formed between the channel region CH and the source region SR.

In an embodiment, the channel region CH may have an asymmetrical shape with respect to a center (e.g., a center line along the second direction or a center line along the first direction) of the channel region CH in a plan view. A resistance (e.g., an increased resistance) may be formed between the source region SR and the gate electrode GE due to the asymmetrical shape of the channel region CH. Specifically, the channel region CH may include a first region A1 adjacent to the source region SR and a second region A2 adjacent to the drain region DR, and an area (or width, e.g., in the second direction) of the first region A1 may be smaller than an area (or width, e.g., in the second direction) of the second region A2. That is, due to a difference in the area (or width) of the first region A1 and the area (or width) of the second region A2, the resistance may be formed between the source region SR and the gate electrode GE. In other words, since the length of the second region A2 in the second direction D2 is greater than the length of the first region A1 in the second direction D2, the resistance may be formed between the source region SR and the gate electrode GE, or the resistance between the source region SR and the gate electrode GE may be greater than a resistance between the drain region DR and the gate electrode GE. The region A1 may be a part of the channel region CH adjacent to the source region and having a first width (in the second direction) and a first length (in the first direction). The region A2 may be a part of the channel region CH adjacent to the source region and having a second width (in the second direction) and a second length (in the first direction). The second width may be greater than the first width. The first length may be greater than the second length.

For example, the asymmetric shape of the channel region CH may be an L-shape in the plan view. However, embodiments of the present disclosure are not necessarily limited thereto.

Since the channel region CH has an asymmetric shape, the driving transistor TR' may have driving characteristics equivalent to driving characteristics of the driving transistor TR illustrated in FIGS. 4 and 5. That is, although the driving transistor TR' does not form the offset region between the source region SR and the channel region CH, since the channel region CH has an asymmetric shape, a sufficient data range may be secured.

In a comparative example, an additional transistor may be connected to a source electrode of a driving transistor instead of a resistance. In this case, a gate electrode of the additional transistor may be connected to the source electrode of the driving transistor. In this case, the driving transistor may secure a sufficient data range. However, since the number of transistors that can be disposed in one pixel of a high-resolution display device is limited, the number of transistors or the size of the transistors may need to be reduced in order to use the additional transistors. In this case, a short channel effect may occur or the image quality characteristics of the display device may deteriorate.

Referring again to FIGS. 1 to 10, in the display device DD according to embodiments of the present disclosure, the offset region OR may be formed between the source region SR and the channel region CH of the driving transistor TR included in each pixel PX, PX', and PX". Alternatively, the channel region CH of the driving transistor TR' may have an asymmetrical shape with respect to the center of the channel region CH. In this case, the resistance R may be formed between the source region SR and the gate electrode GE by the offset region OR or the asymmetrical shape of the channel region CH. Accordingly, the driving transistor TR and TR' may secure a sufficient data range. In addition, if the display device DD has a high resolution, the integration density may be improved. Accordingly, the short channel effect may not occur, and the image quality characteristics of the display device DD may not be deteriorated.

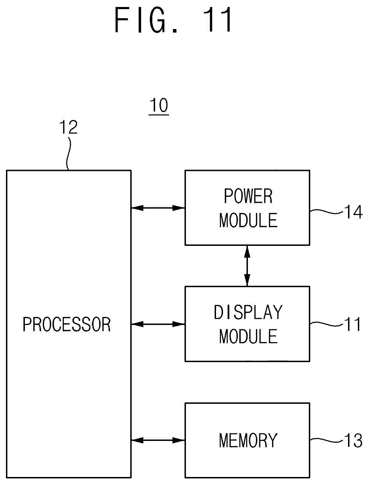

FIG. 11 is a block diagram illustrating an electronic device according to embodiments of the present disclosure.

Referring to FIG. 11, an electronic device 10 according to embodiments of the present disclosure may include a display module 11, a processor 12, a memory 13, and a power module 14. A display device (e.g., the display device DD of FIG. 1) according to embodiments of the present disclosure may be applied to various electronic devices. The electronic device 10 may include the display device described above, and may further include a module or device having additional functions in addition to the display device.

The processor 12 may include at least one of a central processing unit (CPU), an application processor (AP), a graphic processing unit (GPU), a communication processor (CP), an image signal processor (ISP) and a controller.

The memory 13 may store data information for the operation of the processor 12 or the display module 11. If the processor 12 executes the application stored in the memory 13, an input image data (e.g., IDAT in FIG. 1) and/or a control signal (e.g., CTRL in FIG. 1) may be transmitted to the display module 11, and the display module 11 may process the received signal and output image information through a display screen.

The power module 14 may include a power supply module, such as a power adapter or a battery device, and a power conversion module, which converts the power supplied by the power supply module to generate power for the operation of the electronic device 10.

At least one of each component of the electronic device 10 described above may be included in the display device according to the above-described embodiments. In addition, some of the individual modules functionally included in one module may be included in the display device, and other portions may be provided separately from the display device. For example, the display device may include the display module 11, and the processor 12, the memory 13, and the power module 14 may be provided in the form of other devices within the electronic device 10 other than the display device.

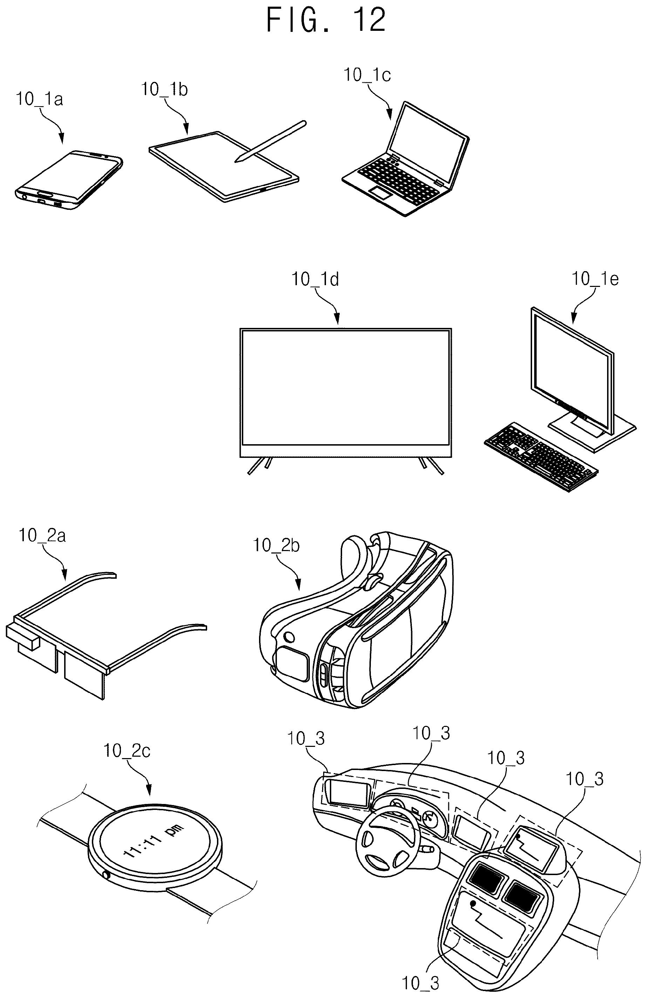

FIG. 12 is a schematic diagram illustrating an electronic device according to various embodiments.

Referring to FIGS. 11 and 12, various electronic devices 10 to which display devices according to the embodiments are applied may include not only image display electronic devices such as a smartphone 10_1a, a tablet PC 100_1b, a laptop 10_1c, a TV 10_1d, and a desktop monitor 10_1e, but also wearable electronic devices including display modules, such as smart glasses 10_2a, a head-mounted display 10_2b, and a smart watch 10_2c, automotive electronic devices 10_3 including display modules, such as a dashboard of a car, a center fascia, a Center Information Display (CID) disposed on a dashboard, and a room mirror display, or the like.

As described above, while the present disclosure has been explained with reference to exemplary embodiments, it will be understood by those of ordinary skill in the art that various modifications and changes can be made thereto without departing from the scope of the invention as defined in the following claims.

The present disclosure may be applied to various display devices, which can be equipped with a display device. For example, the present disclosure may be applied to high-resolution smartphones, mobile phones, smart pads, smart watches, tablet PCs, vehicle navigation systems, televisions, computer monitors, and notebook computers.

**Claims**

**1.** A pixel (PX) comprising:

a driving transistor (TR) including:

a source region (SR) electrically connected to a driving voltage line, which receives a driving voltage and disposed in one side of a semiconductor substrate (SUB);
a drain region (DR) disposed in an opposite side of the semiconductor substrate (SUB);
a channel region (CH) disposed in a portion of the semiconductor substrate (SUB) between the source region (SR) and the drain region (DR);
an insulating layer (IL) disposed on the channel region (CH); and
a gate electrode (GE) disposed on the insulating layer (IL) and overlapping the channel region (CH) in a plan view, wherein the driving transistor (TR) is configured to generate a driving current and an offset region (OR) is formed between the source region (SR) and the channel (CH) region in the driving transistor (TR) in the plan view; and

a light-emitting element (LED), which generates light based on the driving current and including an anode electrode and a cathode electrode.

2. The pixel (PX) of claim 1, wherein a resistance is formed in the offset region (OR) between the source region (SR) and the gate electrode (GE).

3. The pixel (PX) of claim 1 or claim 2, wherein the gate electrode (GE) partially overlaps the channel region (CH) and does not overlap the source region (SR) in the plan view.

4. The pixel (PX) of one of the preceding claims, wherein a shortest length of the offset region (OR) in the plan view is 1.7 to 10 times a thickness of the insulating layer (IL).

5. The pixel (PX) of one of the preceding claims, wherein a common voltage line, which receives a common voltage is connected to the cathode electrode, and
a voltage level of the driving voltage is higher than a voltage level of the common voltage.

6. The pixel (PX) of one of the preceding claims, wherein at least a portion of the semiconductor substrate (SUB) contacting the source region (SR) and the drain region (DR) is doped with n-type impurities.

7. The pixel (PX) of one of the preceding claims, wherein the source region (SR) and the drain region (DR) are doped with p-type impurities, respectively.

8. The pixel (PX) of one of the preceding claims, further comprising:

a first switching transistor including a first source electrode connected to a data line, a first gate electrode connected to a first gate signal line, and a first drain electrode connected to a first node;
a second switching transistor including a second source electrode connected to the drain region of the driving transistor, a second gate electrode connected to an emission control line, and a second drain electrode connected to a second node;
a third switching transistor including a third source electrode connected to an initialization voltage line, a third gate electrode connected to a second gate signal line, and a third drain electrode connected to the second node; and
a storage capacitor connected between the first node and the driving voltage line,
wherein the gate electrode of the driving transistor is connected to the first node, and the anode electrode is connected to the second node.

9. The pixel (PX') of one of claims 1 to 7, further comprising:

a first switching transistor including a first source electrode connected to a data line, a first gate electrode connected to a first gate signal line, and a first drain electrode connected to a first node;
a second switching transistor including a second source electrode connected to the first node, a second gate electrode connected to a second gate signal line, and a second drain electrode connected to a second node;
a third switching transistor including a third source electrode connected to the second node, a third gate electrode connected to a first emission control line, and a third drain electrode connected to a third node;
a fourth switching transistor including a fourth source electrode connected to an initialization voltage line, a fourth gate electrode connected to a third gate signal line, and a fourth drain electrode connected to the third node;

a fifth switching transistor including a fifth source electrode connected to the driving voltage line, a fifth gate electrode connected to a second emission control line, and a fifth drain electrode connected to the source region of the driving transistor;
a first capacitor connected between the first node and the first switching transistor; and
a second capacitor connected between the first node and the driving voltage line,
wherein the gate electrode of the driving transistor is connected to the first node, and the anode electrode is connected to the third node.

10. The pixel (PX") of one of claims 1 to 7, further comprising:

a first switching transistor including a first source electrode connected to a data line, a first gate electrode connected to a first gate signal line, and a first drain electrode connected to a third node;
a second switching transistor including a second source electrode connected to a first node, a second gate electrode to a second gate signal line, and a second drain electrode to a second node;
a third switching transistor including a third source electrode connected to the second node, a third gate electrode connected to an emission control line, and a third drain electrode connected to a fourth node;
a fourth switching transistor including a fourth source electrode connected to an initialization voltage line, a fourth gate electrode connected to a third gate signal line, and a fourth drain electrode connected to the fourth node;
a fifth switching transistor including a fifth source electrode connected to a reference voltage line, a fifth gate electrode connected to a fourth gate signal line, and a fifth drain electrode connected to the third node;
a sixth switching transistor including a sixth source electrode connected to the reference voltage line, a sixth gate electrode connected a fifth gate signal line, and a sixth drain electrode connected to the first node; and
a storage capacitor connected between the first node and the third node;
wherein the gate electrode of the driving transistor is connected to the first node, and the anode electrode is connected to the fourth node.

11. A pixel (PX) comprising:

a driving transistor (TR') including:

a source region (SR) electrically connected to a driving voltage line, which receives a driving voltage and disposed in one side of a semiconductor substrate (SUB);
a drain region (DR) disposed in an opposite side of the semiconductor substrate (SUB);
a channel region (CH) disposed in a portion of the semiconductor substrate (SUB) between the source region (SR) and the drain region (DR) and having an asymmetrical shape with respect to a center of the channel (CH) region in a plan view;
an insulating layer (IL) disposed on the channel region (CH); and
a gate electrode (GE) disposed on the insulating layer (IL) and overlapping the channel region (CH) in the plan view, wherein the driving transistor (TR') is configured to generate a driving current; and

a light-emitting element (LED), which generates light based on the driving current and including an anode electrode and a cathode electrode.

12. The pixel (PX) of claim 11, wherein a resistance is formed between the source region (SR) and the gate electrode (GE) by the asymmetrical shape of the channel region (CH).

13. The pixel (PX) of claim 11 or claim 12, wherein the asymmetrical shape of the channel region (CH) is an L-shape in the plan view.

14. The pixel (PX) of one of claims 11 to 13, wherein the channel region (CH) includes a first region (A1) adjacent to the source region (SR) and a second region (A2) adjacent to the drain region (DR), and
an area of the first region (A1) is smaller than an area of the second region (A2).

15. An electronic device comprising:

a display device including:

a display panel (110) including a plurality of pixels (PX) according to one of the preceding claims;

a data driver (140), which provides a data voltage to the pixels;
a gate driver (120), which provides a gate signal to the pixels;
an emission driver (130), which provides an emission control signal to the pixels;
a controller (150), which controls the data driver (140), the gate driver (120), and the emission driver (130), and receives an input image data and a control signal; and

a processor (12), which provides the input image data and the control signal to the controller (150).

# FIG. 1

DD

CTRL, IDAT → CONTROLLER (150)

ECTRL
DCTRL, ODAT
GCTRL

DATA DRIVER (140)
GATE DRIVER (120)
EMISSION DRIVER (130)

DISPLAY PANEL (110)

DATA, DL1, DL2, ... DLm
GS, GL1, GL2, ... GLn
EM, EL1, EL2, ... ELn

PX

ELVDD, ELVSS

# FIG. 2

# FIG. 3

CF1  BM  CF2  CF3

ES

ADL
ML

TFE3
TFE2 } TFE
TFE1
CE
EML
PW

PXC_IL

PXC

SUB

110

PE1  PE2  PE3

PXA1  PXA2  PXA3

D3

LED1 { PE1, EML, CE    LED2 { PE2, EML, CE    LED3 { PE3, EML, CE

# FIG. 4

# FIG. 5

# FIG. 6

# FIG. 7

# FIG. 8

# FIG. 9

# FIG. 10

# FIG. 11

10

12

PROCESSOR

POWER
MODULE ~14

DISPLAY
MODULE ~11

MEMORY ~13

# FIG. 12

Europäisches Patentamt

European Patent Office

Office européen des brevets

## EUROPEAN SEARCH REPORT

**Application Number**

EP 25 21 9037

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/172679 A1 (AKIYAMA TAKAHIRO [JP] ET AL) 2 June 2022 (2022-06-02) | 1-3, 5-10,15 | INV. H10D30/60 |
| Y | * paragraph [0029] * | 11-14 | G09G3/3233 |
| A | * paragraph [0033] * | 4 | H10D62/10 |
| | * paragraph [0035] - paragraph [0036] * | | H10K59/12 |
| | * paragraph [0042] * | | |
| | * paragraph [0044] * | | |
| | * paragraph [0051] - paragraph [0053] * | | |
| | * figure 2 * | | |
| | * figure 4 * | | |
| | * figure 3 * | | |
| | ----- | | |
| Y | US 2017/278917 A1 (KIM JONGYUN [KR]) 28 September 2017 (2017-09-28) | 11-14 | |
| A | * paragraph [0051] * | 4 | |
| | * figure 3 * | | |
| | * figure 9 * | | |
| | * figure 10 * | | |
| | ----- | | |
| A | US 2008/278464 A1 (YAMAMOTO TETSURO [JP] ET AL) 13 November 2008 (2008-11-13) | 1-15 | |
| | * paragraph [0037] * | | **TECHNICAL FIELDS SEARCHED (IPC)** |
| | * paragraph [0052] - paragraph [0053] * | | G09G |
| | * paragraph [0059] * | | H10D |
| | * paragraph [0083] * | | H10K |
| | * figure 2 * | | |
| | * figure 4a * | | |
| | ----- | | |
| A | US 2005/012100 A1 (KOO JAE-BON [KR] ET AL) 20 January 2005 (2005-01-20) | 1-15 | |
| | * paragraph [0051] - paragraph [0056] * | | |
| | * figure 5 * | | |
| | * figure 6 * | | |
| | * figures 7A-7B * | | |
| | * figures 8A-8B * | | |
| | * figure 9 * | | |
| | ----- | | |
| | -/-- | | |

The present search report has been drawn up for all claims

| Place of search | Date of completion of the search | Examiner |
|---|---|---|
| Munich | 13 May 2026 | Feil, Maximilian |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

page 1 of 2

Europäisches
Patentamt

European
Patent Office

Office européen
des brevets

## EUROPEAN SEARCH REPORT

**Application Number**

EP 25 21 9037

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 083 990 A1 (SAMSUNG DISPLAY CO LTD [KR]) 2 November 2022 (2022-11-02) * figure 2 * ----- | 1-15 | |
| | | | **TECHNICAL FIELDS SEARCHED (IPC)** |

The present search report has been drawn up for all claims

| Place of search | Date of completion of the search | Examiner |
|---|---|---|
| Munich | 13 May 2026 | Feil, Maximilian |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

............................................................................
& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 25 21 9037

13-05-2026

| Patent document cited in search report | | | Publication date | Patent family member(s) | | Publication date |
|---|---|---|---|---|---|---|
| US 2022172679 | A1 | | 02-06-2022 | JP | 7543104 B2 | 02-09-2024 |
| | | | | JP | 2022085258 A | 08-06-2022 |
| | | | | US | 2022172679 A1 | 02-06-2022 |
| US 2017278917 | A1 | | 28-09-2017 | KR | 20170113865 A | 13-10-2017 |
| | | | | US | 2017278917 A1 | 28-09-2017 |
| US 2008278464 | A1 | | 13-11-2008 | CN | 101303825 A | 12-11-2008 |
| | | | | JP | 2008281671 A | 20-11-2008 |
| | | | | KR | 20080099800 A | 13-11-2008 |
| | | | | TW | 200903423 A | 16-01-2009 |
| | | | | US | 2008278464 A1 | 13-11-2008 |
| US 2005012100 | A1 | | 20-01-2005 | CN | 1577457 A | 09-02-2005 |
| | | | | US | 2005012100 A1 | 20-01-2005 |
| | | | | US | 2008191969 A1 | 14-08-2008 |
| | | | | US | 2013113765 A1 | 09-05-2013 |
| EP 4083990 | A1 | | 02-11-2022 | CN | 115273730 A | 01-11-2022 |
| | | | | EP | 4083990 A1 | 02-11-2022 |
| | | | | KR | 20220148972 A | 08-11-2022 |
| | | | | US | 2022351673 A1 | 03-11-2022 |
| | | | | US | 2024105113 A1 | 28-03-2024 |

EPO FORM P0459

For more details about this annex : see Official Journal of the European Patent Office, No. 12/82